# FASCICULE DE BREVET EUROPEEN

(11) **EP 0 622 836 B1**
(45) Date de publication et mention de la délivrance du brevet: **06.09.2000**
(21) Numéro de dépôt: 94400919.0
(22) Date de dépôt: 28.04.1994
(51) Int. Cl.: H01L 21/58, H01L 21/60

(54) **Procédé d'enrobage de composants électroniques hybrides par billes sur un substrat**
Verfahren zur Umhüllung von elektronischen Hybridbauteilen mittels Kugeln auf einem Substrat
Encapsulating process for electronic hybrid components enabled by spheres on a substrat

(30) Priorité: 30.04.1993 FR 9305146
(43) Date de publication de la demande: 02.11.1994
(73) Titulaire: COMMISSARIAT A L'ENERGIE ATOMIQUE, 75015 Paris Cédex 15 (FR)
(72) Inventeur: Marion, François, F-38120 Saint Egrève (FR); Boitel, Michelle, F-38600 Fontaine (FR)
(74) Mandataire: Dubois-Chabert, Guy

(56) Documents cités:
- FR-A- 2 124 488
- US-A- 4 567 505
- PATENT ABSTRACTS OF JAPAN vol. 16, no. 67 (E-1168)19 Février 1992 & JP-A-03 261 154 (SHARP CORP)
- PATENT ABSTRACTS OF JAPAN vol. 8, no. 285 (E-287)26 Décembre 1984 & JP-A-59 152 652 (NIPPON TOKUSHU TOGYO KK)
- IBM TECHNICAL DISCLOSURE BULLETIN. vol. 33, no. 7 , Décembre 1990 , NEW YORK US pages 477 - 478 'Method to Shield the Exposed Sites near a Chip During Encapsulation of C-4 Chip Joints in a Second Level Packaging Assembly'

## Description

### Domaine technique

La présente invention a pour objet un procédé pour enrober des composants électroniques hybridés par billes sur un substrat. Elle concerne en outre le composant électronique enrobé obtenu par la mise en oeuvre de ce procédé. Elle trouve de nombreuses applications dans les domaines de la microélectronique, de l'informatique, de l'optoélectronique et des microcapteurs.

### Etat de la technique

On cherche de plus en plus à miniaturiser les systèmes électroniques ou informatiques utilisant des circuits intégrés.

Dans le but de réaliser des circuits complexes denses, il est connu de supprimer les boîtiers électroniques autour des puces et d'hybrider directement les puces avec des billes de soudure sur des substrats multicouches réalisant les interconnexions entre les puces. Cette première technique dite "flip-chip" conduit à l'hybridation de centaines de puces sur des substrats céramiques (technique "muti-chip module"). Elle est décrite, par exemple, dans le brevet d'IBM publié sous le numéro US-A-4 202 007 et dans le document FR-A-2 611 986 (Thomson Semiconducteurs).

L'augmentation, par cette technique d'hybridation par billes, du nombre de composants par unité de surface de substrat nécessite une attention accrue aux problèmes de tenue mécanique des circuits ainsi réalisés. Un procédé pour améliorer la résistance mécanique de tels circuits est connu et expliqué dans l'article intitulé : "Development of a high reliability flip chip packaging reinforced by resin" publié dans "Electronics and communications in Japan", part 2 vol. 71, n° 11, 1988, p. 19, et dans le document "Flip chip solder bump fatigue life enhanced by polymer encapsulation", de "Proceeding 40th Electronic components and technology conference", 1990, p. 338.

Le procédé décrit dans ces documents est un procédé d'enrobage des composants électroniques. Ce procédé consiste à déposer une goutte calibrée d'une substance d'enrobage telle qu'une résine d'enrobage (appélée plus simplement, par la suite, résine). Cette goutte calibrée de résine est déposée près du composant électronique hybridé par billes, ce composant électronique étant, dans la plupart des cas, une puce électronique. La goutte de résine déposée près du composant électronique migre par capillarité sous le composant électronique, c'est-à-dire que cette goutte de résine migre vers les billes du composant hybridé situées entre le composant et le substrat.

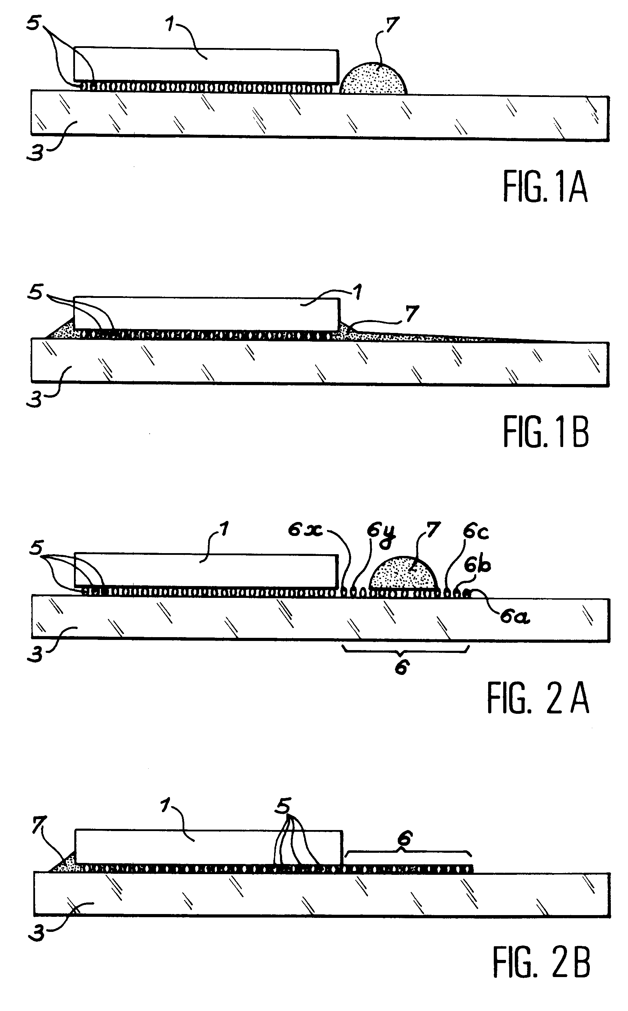

On a représenté, sur les figures 1A et 1B, un substrat 3 sur lequel est monté un composant électronique 1 hybridé par billes (nommé plus simplement, composant hybridé). Sur la figure 1A, on a représenté une goutte de résine 7 déposée à proximité du composant électronique 1. Cette goutte de résine 7 doit être calibrée de façon à ce que la quantité de résine qu'elle contient soit suffisamment importante pour migrer par capillarité vers les billes du composant hybridé 1, c'est-à-dire pour migrer par capillarité entre les billes 5 situées entre le composant 1 et le substrat 3.

Sur la figure 1B, on a représenté ce même substrat 3 sur lequel est monté le composant 1 hybridé par les billes 5. Cette figure 1B montre la goutte de résine 7 qui a migré sous le composant hybridé 1. La résine employée est, par nature, de faible viscosité et a donc tendance à s'étendre facilement. Aussi, le surplus de résine 7 qui n'a pas pénétré entre les billes 5 du composant hybridé 1 s'étale de part et d'autre du composant 1. On comprend bien, de ce fait, que la goutte de résine 7 doit être correctement calibrée de façon à ce que la quantité de résine qu'elle contient soit suffisamment importante pour combler entièrement l'espace contenu entre le composant hybridé 1 et le substrat 3, mais pas trop importante de façon à ce que la résine ne s'étale pas de façon trop importante autour dudit composant hybridé 1 comme cela est représenté sur la figure 1B. En outre, afin de limiter cet "étalement" non désirable de la résine autour du composant hybridé 1, la goutte de résine 7 doit être déposée très précisément au bord du composant hybridé 1. En effet, si la goutte de résine 7 a un volume trop important, la résine risque de s'étendre largement autour du composant 7 recouvrant, de ce fait, des zones qui sont proches dudit composant 1 et ne devaient pas être recouvertes. C'est le cas, par exemple, pour les substrats sur lesquels sont montés des multi-ships modules ou des zones comportant des plots de test à pointe qui ne doivent pas être recouverts de résine.

### Exposé de l'invention

La présente invention a justement pour but de remédier aux inconvénients cités précédemment. A cette fin, elle propose un procédé d'enrobage d'un composant hybridé par billes sur un substrat, dans lequel la localisation de la résine peut être contrôlée pendant et après l'opération d'enrobage dudit composant hybridé.

De façon plus précise, l'invention concerne un procédé d'enrobage d'un composant électronique monté, selon une technique d'hybridation par billes, sur un substrat. Ce procédé consiste :
- à disposer une multitude des billes sur le substrat, autour du composant électronique pour former un tapis de billes contigü audit composant électronique ;
- à déposer au moins une goutte d'une substance d'enrobage sur le tapis de billes, les billes du tapis imprégnées de la substance d'enrobage étant aptes à faire migrer cette substance d'enrobage par capillarité vers les billes situées entre ledit composant électronique et le substrat.

Un tel tapis de billes permet de contrôler la localisation de la résine qui reste confinée dans le tapis. En outre, il permet de déposer la goutte de substance avec une tolérance de positionnement très large, la goutte pouvant être déposée en n'importe quel endroit du tapis de billes.

Avantageusement, ce procédé consiste à choisir les dimensions du tapis de billes en fonction de la quantité de résine à y déposer.

Le procédé peut consister en outre à réaliser le tapis de billes avec des billes de dimensions variables, afin que la force de capillarité s'intensifie du bord extérieur du tapis vers les billes situées entre le composant électronique et le substrat.

L'invention concerne en outre un composant électronique enrobé, monté sur un substrat selon une technique d'hybridation par billes, caractérisé en ce qu'il est, au moins en partie, entouré d'un tapis de billes disposé sur le substrat contigument aux billes d'hybridation et imprégné d'une substance d'enrobage.

### Brève description des dessins

- La figure 1A, déjà décrite, représente un composant électronique hybridé par billes à côté duquel est disposée la goutte de résine permettant son enrobage ;
- la figure 1B, également décrite, représente le composant électronique hybridé par billes enrobé d'une résine ;
- la figure 2A représente un composant électronique hybridé par billes et entouré d'un tapis de billes sur lequel est déposée une goutte de résine ;
- la figure 2B, représente un composant électronique hybridé par billes et enrobé d'une couche de résine ; et

### Exposé détaillé de modes de réalisation

Un mode de réalisation de l'invention est montré sur les figure 2A et 2B. Sur 1a figure 2A, on a représenté le composant hybridé 1 monté sur le substrat 3 selon une hybridation par les billes 5. Sur cette figure 2A, on a représenté le tapis 6 de billes réalisé au moyen d'une multitude de billes (6a, 6b, 6c, ...) identiques aux billes 5 du composant hybridé 1. Ce tapis 6 de billes est disposé de façon contiguë aux billes 5 du composant hybridé 1. Une goutte de résine 7 peut ainsi être déposée sur ce tapis 6 de billes. Cette résine 7 peut alors s'étendre à toutes les billes du tapis 6 de billes ainsi qu'à toutes les billes de la surface sous le composant hybridé 1, sous l'effet des forces de capillarité. La résine est alors retenue, par les forces de capillarité, dans la limite du tapis 6 de billes.

La goutte de résine peut être déposée en n'importe quelle position du tapis 6 de billes. Cette goutte de résine 7 est alors automatiquement aspirée par le tapis 6 de billes et dirigée vers le composant hybridé 1 contigu sous lequel la résine est également aspirée, par capillarité, par les billes du composant hybridé 1. L'excédent de résine dispensé reste confiné dans le tapis 6 de billes, permettant, ainsi, une maîtrise parfaite de l'opération.

Sur la figure 2B, on peut voir le composant hybridé 1 entouré du tapis 6 de billes dans lequel a pénétré la résine 7. Le composant hybridé 1 est alors enrobé de résine 7 selon une localisation contrôlée. En effet, comme on peut le voir sur la figure 2B, toute la résine 7 est absorbée par les billes 5 du composant hybridé 1 et du tapis.

De façon avantageuse, les billes du tapis 6 peuvent être de dimensions différentes les unes des autres, de manière à favoriser les effets de diffusion par capillarité de la résine 7. De préférence, les billes 6a, 6b 6c,...situées sur la partie extérieure du tapis 6 sont de taille inférieure à celle des billes 6x, 6y,... situées sur la partie du tapis 6 contiguë au composant hybridé 1. Il est ainsi possible de limiter l'extension de la résine 7 autour du composant hybridé 1, c'est-à-dire de limiter la taille du tapis 6, en utilisant, pour réaliser le tapis, des billes d'une hauteur suffisamment importante.

Il est en outre possible de contrôler l'épaisseur de la résine 7 autour du composant hybridé 1 en choisissant la ou les hauteur(s) des billes à utiliser pour réaliser le tapis 6. Si l'on désire obtenir une épaisseur de résine constante, les billes utilisées pour réaliser le tapis 6 doivent être de taille identique.

Ce procédé selon l'invention permet donc un contrôle parfait de la répartition de la résine d'enrobage pendant et après l'opération d'enrobage, les zones comportant de la résine autour du composant hybridé 1 étant parfaitement contrôlé.

En outre, ce procédé selon l'invention permet de déposer la goutte de résine 7 en un lieu pas très précis. Les gouttes de résine 7 peuvent en effet être déposées loin du composant hybridé 1, tout en étant déposées sur le tapis 6, et avec des tolérances de positionnement très larges, les forces de capillarité assurant la propagation de la résine vers les billes du composant hybridé 1.

On peut citer, à titre d'exemple, et pour permettre une meilleure compréhension de l'invention, le cas d'un composant hybridé de surface 1 cm x 1 cm hybridé sur un substrat par des billes de hauteur 50 µm, les billes pouvant généralement avoir une hauteur de sensiblement 1 à 200 µm. Le volume minimum de la goutte de résine à dispenser est alors de 5 mm3. Après enrobage du composant hybridé, le résidu de résine s'étendrait jusqu'à 7 mm s'il n'y avait pas de tapis de billes. Selon l'invention, le tapis 6 de billes limite cette extension de la résine à 4 mm.

Ce procédé permet, comme on l'a sans doute déjà compris, de réaliser toutes sortes de géométrie du tapis de billes.

Selon un avantage de l'invention, le tapis de billes peut être réalisé lors des mêmes opérations technologiques que celles permettant la réalisation des billes d'hybridation du composant hybridé, aucune étape technologique supplémentaire n'étant nécessaire.

Ces billes peuvent, par exemple, être réalisées par croissance électrolytique d'une couche d'un matériau à bas point de fusion (par exemple Sn-Pb) au-dessus d'une surface mouillable (par exemple une surface d'or) de surface plus faible. Ces billes peuvent ensuite être mises en forme par fusion du matériau, les forces de tension superficielles formant les billes soudées sur la surface mouillable. Des modes de réalisation de ces billes utilisées pour l'hybridation de composants électroniques sont décrits dans les documents cités précédemment.

## Revendications

1. Procédé d'enrobage d'un composant électronique monté (1), selon une technique d'hybridation par billes (5), sur un substrat (3), comprenant les étapes suivantes:
- disposer une multitude de billes (6a, 6b, 6c) sur le substrat, autour dudit composant électronique monté pour former un tapis de billes (6) contigü audit composant électronique ;
- déposer au moins une goutte (7) d'une substance d'enrobage sur le tapis de billes, les billes du tapis imprégnées de la substance d'enrobage étant aptes à faire migrer cette substance d'enrobage, par capillarité, vers les billes situées entre ledit composant électronique et le substrat.

2. Procédé selon la revendication 1, caractérisé en ce qu'il consiste à choisir les dimensions du tapis de billes en fonction de la quantité de substance à y déposer.

3. Procédé selon l'une quelconque des revendications 1 et 2, caractérisé en ce qu'il consiste à réaliser le tapis de billes avec des billes de dimensions variables afin d'assurer une force de capillarité plus intense d'un bord extérieur du tapis vers les billes situées entre le composant électronique et le substrat.

4. Composant électronique enrobé, monté sur un substrat selon une technique d'hybridation par billes, caractérisé en ce qu'il est, au moins en partie, entouré d'un tapis de billes disposé sur le substrat contigument aux billes d'hybridation et imprégné d'une substance d'enrobage.

## Claims

1. Process for coating an electronic component (1) fitted on a substrate (3) using a bump (5) hybridization procedure, comprising placing a plurality of bumps (6a, 6b, 6c) on the substrate around said fitted electronic component in order to form a belt of bumps (6) contiguous to said electronic component and depositing at least one drop (7) of a coating substance on the bump belt, the bumps of the belt impregnated with coating substance being able to make said substance migrate by capillarity towards the bumps located between said electronic component and said substrate.

2. Process according to claim 1, characterized in that it consists of choosing the dimensions of the bump belt as a function of the substance quantity to be deposited there.

3. Process according to either of the claims 1 and 2, characterized in that it consists of producing the bump belt with bumps having variable dimensions, in order to ensure a more intense capillarity force from an outer edge of the belt towards the bumps located between the electronic component and the substrate.

4. Coated electronic component fitted to a substrate according to a bump hybridization procedure, characterized in that it is at least partly surrounded by a bump belt placed on the substrate contiguous to the hybridization bumps and impregnated with a coating substance.

## Patentansprüche

1. Verfahren zur Umhüllung eines durch die Technik der Hybridisierung mittels Kugeln (5) auf ein Substrat (3) montierten elektronischen Bauteils, folgende Schritte umfassend:
- Anbringen einer Vielzahl Kugeln (6a, 6b, 6c) auf dem Substrat, um das genannte montierte Bauteil herum, um einen an das elektronische Bauteil angrenzenden Teppich aus Kugeln (6) zu bilden;
- Anbringen wenigstens eines Tropfens (7) einer Umhüllungssubstanz auf dem Kugelteppich, wobei die mit der Umhüllungssubstanz imprägnierten Kugeln des Teppichs diese Substanz durch Kapillarwirkung zu den Kugeln wandern lassen, die sich zwischen dem genannten elektronischen Bauteil und dem Substrat befinden.

2. Verfahren nach Anspruch 1, dadurch gekennzeichnet, dass es darin besteht, die Abmessungen des Kugelteppichs in Abhängigkeit von der Menge der aufzubringenden Substanz zu wählen.

3. Verfahren nach einem der Ansprüche 1 und 2, dadurch gekennzeichnet, dass es darin besteht, den Kugelteppich aus Kugeln variabler Dimensionen zu realisieren, um eine Kapillarwirkungskraft sicherzustellen, die von einem Außenrand des Teppichs stärker wird in Richtung der zwischen dem Substrat und dem elektronischen Bauteil befindlichen Kugeln.

4. Umhülltes elektronisches Bauteil, auf ein Substrat montiert nach einer Hybridisierungstechnik mittels Kugeln,
**dadurch gekennzeichnet**, dass es wenigstens teilweise von einem auf dem Substrat realisierten Teppich aus an die Hybridisierungskugeln angrenzenden Kugeln umgeben ist und mit einer Umhüllungssubstanz imprägniert ist.
